**Europäisches Patentamt**

**European Patent Office**

**Office européen des brevets**

(11) Publication number: **0 116 266**
**B1**

(12) **EUROPEAN PATENT SPECIFICATION**

(45) Date of publication of patent specification: **26.08.87**

(21) Application number: **83850319.1**

(22) Date of filing: **29.11.83**

(51) Int. Cl.⁴: **H 01 R 13/62**

(54) **Holder for connecting electrical conductors to contact surfaces on electronic components.**

(30) Priority: **29.12.82 SE 8207492**

(43) Date of publication of application:
**22.08.84 Bulletin 84/34**

(45) Publication of the grant of the patent:
**26.08.87 Bulletin 87/35**

(84) Designated Contracting States:
**CH DE FR GB IT LI NL**

(56) References cited:
**DE-A-1 934 752**
**DE-A-2 046 729**
**GB-A-1 246 101**
**GB-A-2 083 298**

**RCA, Technical notes, no. 1315, 12 October 1982**

(73) Proprietor: **TELEFONAKTIEBOLAGET L M ERICSSON**
**S-126 25 Stockholm (SE)**

(72) Inventor: **Andersson, Folke Oskar Anders**
**Klintvägen 9A**
**S-135 00 Tyresö (SE)**
Inventor: **Larsson, Hakan Anders**
**Björksäter Odensala**
**S-195 00 Märsta (SE)**

(74) Representative: **Johnsson, Helge et al**
**Telefonaktiebolaget L M Ericsson**
**S-126 25 Stockholm (SE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

### Technical Field

The invention comprises a holder for connecting electrical conductors to contact surfaces on electronic components.

### Background Art

Modern electronic systems contain miniaturized components to a large extent. These are electrically connected to printed circuit boards by contact surfaces on the component. The contact surfaces may be accessible from the outside on assembled components, whereon the function of both component and connections can be checked. However, difficulties arise in connecting measuring means for such a check, since the components are small and have many contact surfaces. The function of the components and the function of the circuit boards are checked separately before the components are connected to the circuit board. However, this check does not give any information with regard to the reliability of the connections or the mutual coaction of the components on the circuit board in a ready-assembled condition.

Particular difficulties in the connecting measuring means occur if the connections between the circuit board and component cannot be reached directly from above, especially if the connections are on all four sides of the component.

In the patent application No. DE—A—1 934 752 is shown a holder for connecting almost parallel contact pins to contact surfaces on an electronic component. The holder has pins for gripping the component, which pins are nearly parallel to the contact pins. The gripping pins and the contact pins are supported by a first block and can be actuated by a second block which is displaceable in the direction of the pins. The holder has the disadvantage that the contact pins and the gripping pins are actuated simultaneously. It is then a risk, especially if the component is small, that the contact pins will come out of their desired position when the component is gripped. No electrical contact will then be established between the contact pins and the contact surfaces.

In the patent application No. DE—A—2 046 722 is shown a holder with two actuators, which are pivotable about a pin. The actuators have contact springs for making electrical contact with the contact surfaces on the component and gripping means for gripping the component and preventing the holder from falling off the component. The holder has the same disadvantage as the holder described above in that the contact springs will make contact before the component is gripped by the gripping means.

### Disclosure of the Invention

The above mentioned problem is solved, in accordance with the invention, by a holder which is formed such that on application to the component it surrounds the component on all sides with both mechanical gripping means and electrical connection means, the latter being connected after the gripping means have fixed the component in its position in the holder.

### Description of Figures

An embodiment of the invention will now be described below in conjunction with the appended drawing, where

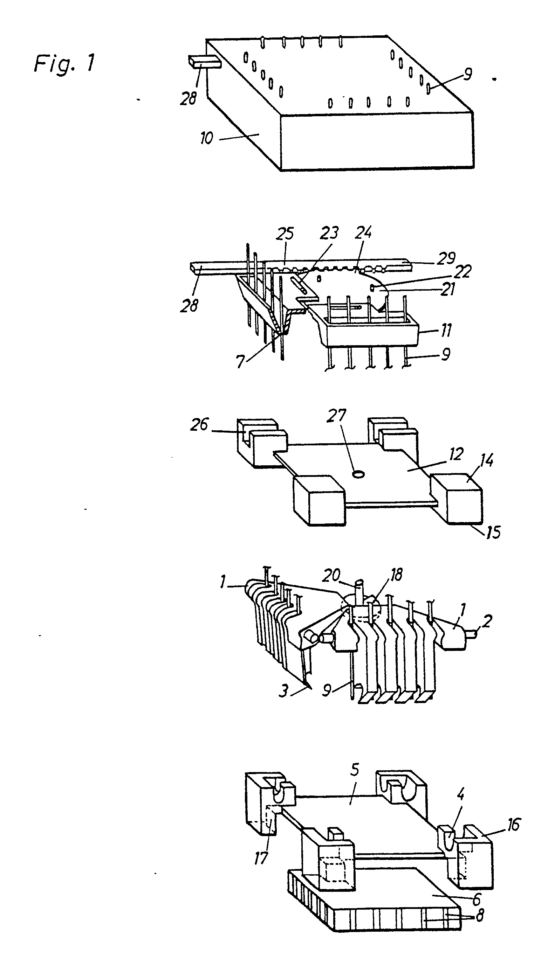

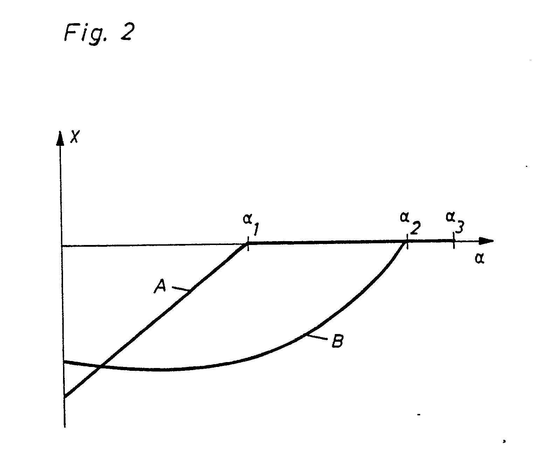

Figure 1 illustrates the apparatus in accordance with the invention in perspective, with the individual parts spaced from each other, and Figure 2 is a diagram illustrating the positional alterations of the gripping means and contact springs as a function of the turning angle of the operating means.

### Preferred Embodiment

In Figure 1 there are illustrated bell crank-shaped gripping means 1, which are pivotable about shafts 2 and are provided with gripping surfaces 3. Two of the gripping means are illustrated, there being four such in opposing pairs. The shafts rest in journalling recesses 4 on a base 5. With their gripping surfaces, the gripping means can grip a component 6, the gripping surfaces 3 resting against the side surfaces of the component between electrically conductive contact surfaces 8. Electrical conductors can be connected to the component at the contact surfaces with the aid of resilient contact pins 9. At their upper ends these are rigidly fastened in a casing 10, and extend out through it to constitute electrical connections. In the casing, the contact pins extend through holes 7 bell crank shaped in actuators 11, so that they are flexibly guided and can be moved to a position of engagement with the contact surfaces 8. The actuators can glide against the inner bottom surface of the casing. A spacer means 12 is placed in the casing under the actuators and rests with its upper surfaces 14 against the inner bottom surface of the casing. The lower surfaces 15 of the spacer means rests against surfaces 16 on the base 5, thereby keeping the shafts 2 in their positions in the journalling recesses 4. The base has recesses 17 for locating the four corners of the component, which can thus be placed in a given position in the holder.

The four gripping means can be turned about their shafts with the aid of a cam means 18 fixed to a shaft 20, with the aid of which it can be turned. The shaft 20 passes through a hole 27 in the spacer means 12. At its other end, the shaft 20 carries another cam means formed as a disc 21 provided with four pins 22, running in slots 23 in the actuators. Along a portion of its periphery the disc 21 is provided with teeth 24 in mesh with a rack 25. The rack rests in recesses 26 made in the spacer means 12. Both end portions 28 and 29 of the rack project out through two holes in the casing.

The gripping means 1 and contact pins 9 are operated in the following manner. By exercising force in an axial direction at the ends of the rack, it can be moved backwards and forwards. This movement is translated via the teeth to the disc 21, which is thus turned. The turning movement is translated to the cam means 18 via the shaft 20. As the shaft is turned the cam means is moved in under the end portions of the gripping means and lifts them. They then pivot about their shafts and the gripping surfaces 3 are moved towards the component for gripping it. After a given amount of turn of the cam means, it lifts no further the end portion of the gripping means, even if turning of the shaft 20 continues. As the shaft turns, the pins 22 move in their respective slots 23 in the actuators. The slots have a position in relation to the shaft 20 such that the radial movement of the actuators will be very small during the first part of the turn of the shaft. On continued turning of the shaft, when the gripping means remain in engagement with the component, the actuators are displaced towards the centre of shaft 20. The contact pins are thus moved into engagement against the contact surfaces 8 of the component. The apparatus will remain in this state due to friction, in spite of the spring bias in the contact pins, even if the exterior forces cease at the ends of the rack.

The gripping means can be provided with returning means, e.g. a further cam means, which pivot the bell crank-shaped arms so that their gripping surfaces move away from the component when the rack 25 is reset.

Figure 2 is a diagram illustrating the movement x of the gripping means and contact pins as a function of the turning angle $a$ of the shaft. As shown by line A, there is a linear change in the distance between the gripping surfaces of the gripping means and the component during the first part. For the angle $a_1$ the gripping means have come into engagement against the side surfaces of the component. The relative positions of the pins 22 and slots 23 are selected such that during this first part of the turning movement there is only a relatively small change in the radial movement of the contact pins, which is shown by the line B. When the cam means has passed the turning angle $a_1$, and the gripping means do not move, the radial distance of the actuators from the shaft decreases until the contact pins come into engagement with the contact surfaces of the component at the turning angle $a_2$. The cam means is then turned to its end position at the angle $a_3$.

It is of course possible for the operation of the contact pins 9 also to take place with bell crank-shaped arms in the same way as for the gripping means, in which case the cam means must be adapted in a corresponding manner.

It is also conceivable that the contact pins come into contact with the component simultaneously as the gripping means or before these. The solution according to the described embodiment gives the most secure electrical contact function, however, and requires small operating forces.

## Claims

1. A holder for connecting electrical contact pins (9) to spaced contact surfaces (8) on side surfaces of an electronic component (6) on a circuit board, the holder comprising a casing, gripping means (1) having gripping surfaces (3) for gripping the side surfaces of the electronic component between the contact surfaces (8) thereon, said gripping means (1) being pivotable from an inoperative rest position to an operative engagement position in which the gripping surfaces (3) come into contact with the side surfaces of the electronic component, the electrical contact pins (9) being supported by the casing in normally spaced relation with the contact surfaces of the component, actuators (11) engaging the contact pins (9) for bringing the pins into operative electrical contact with the contact surfaces (8) of the component, and operating means (20) for pivoting the gripping means (1) to its operative position and for moving the actuators (11) and thereby the contact pins (9) into contact with the contact surfaces of the component, characterized by the operating means (20) being able to execute a turning movement and including a first rotatable cam means (18) for operating the gripping means (1) and a second rotatable cam means (21) for operating the actuators (11) and in that the first (18) and second (21) rotatable cam means are formed such that the gripping means (1) is first pivoted to its operative engagement position and thereafter the contact pins (9) are moved into contact with the contact surfaces (8) by the actuators (11).

2. Holder as claimed in claim 1 characterized in that the gripping means (1) are bell crank-shaped and that the first rotatable cam means (18) is acting in the direction of the turning axis of the operating means on one arm of the bell crank during the turning movement so that the other arm is moved towards the turning axis and in that the second rotatable cam means is (21) provided with pins (22) at a radial distance from the turning axis, said pins (22) projecting into slots (23) extending in the actuators (11) in a transverse direction to the turning axis such that when the operating means is turned the actuators (11) are subjected to a displacing movement in a transverse direction towards the turning axis.

## Patentansprüche

1. Halter zum Verbinden elektrischer Kontaktstifte (9) mit mit Abstand zueinander angeordneten Kontaktflächen (8) auf Seitenflächen eines elektronischen Bauteils (6) auf einer Schaltungsplatte, mit einem Gehäuse, Greifmitteln (1) mit Greifflächen zum Greifen der Seitenflächen des elektronischen Bauteils zwischen den Kontaktflächen (8) hieran, wobei die Greifmittel (1) aus einer nicht wirksamen Ruheposition in eine wirksame Eingriffsposition schwenkbar sind, in welcher die Greifflächen (3) in Kontakt mit den Seitenflächen des elektronischen Bauteils kommen, und wobei die elektrischen Kontaktstifte (9) von dem Gehäuse in normal beabstandeter Relation zu den Kontaktflächen des Bauteils gehalten sind, Betätigungsorganen (11), welche die Kontaktstifte (9) zum Bringen der Stifte in wirksamen elektrischen Kontakt mit den Kontaktflächen (8) des Bauteils erfassen, und Betriebsmitteln (20) zum Schwenken der Greifmittel (1) in deren wirksame Position und zum Bewegen der Betätigungsorgane (11) und hierdurch der Kontaktstifte (9) in Kontakt mit den Kontaktflächen des Bauteils, dadurch gekennzeichnet, daß die Betriebsmittel (20) in der Lage sind, eine Drehbewegung auszuführen, und erste drehbare Nockenmittel (18) zum Betreiben der Greifmittel (1) und zweite drehbare Nockenmittel (21) zum Betreiben der Betätigungsorgane (11) aufweisen, und daß die ersten (18) und zweiten (21) drehbaren Nockenmittel derart ausgebildet sind, daß durch die Betätigungsorgane (11) die Greifmittel (1) erst in deren wirksame Eingriffsposition geschwenkt und hierauf die Kontaktstifte (9) in Kontakt mit den Kontaktflächen (8) bewegt werden.

2. Halter nach Anspruch 1, dadurch gekennzeichnet, daß die Greifmittel (1) winkelhebelförmig sind, und daß die ersten drehbaren Nockenmittel (18) in der Richtung der Drehachse der Betriebsmittel auf einen Arm des Winkelhebels derart während der Drehbewegung wirken, daß der andere Arm zu der Drehachse hin bewegt wird, und daß die zweiten drehbaren Nockenmittel (21) mit Stiften (22) mit einem radialen Abstand von der Drehachse versehen sind, wobei diese Stifte (22) in Schlitze (23) ragen, welche sich in den Betätigungsorganen (11) in einer Querrichtung zu der Drehachse derart erstrecken, daß die Betätigungsorgane (11) beim Drehen der Betriebsmittel einer Verschiebebewegung in einer Querrichtung zur Drehachse hin unterworfen werden.

**Revendications**

1. Monture pour connecter des broches (9) de contact électrique à des surfaces de contacts espacées (8) situées sur des surfaces latérales d'un composant électronique (6) sur une plaquette à circuit, la monture comprenant un boîtier, des moyens de prise (1) présentant des surfaces de prise (3) destinées à prendre les surfaces latérales du composant électronique entre ses surfaces de contact (8), lesdits moyens de prise (1) pouvant pivoter d'une position inactive de repos vers une position active de prise dans laquelle les surfaces de prise (3) viennent en contact avec les surfaces latérales du composant électronique, les broches de contact électrique (9) étant supportées par le boîtier de façon à être normalement espacées des surfaces de contacts du composant, des actionneurs (11) portant contre les broches (9) de contact pour amener les broches en contact électrique actif avec les surfaces de contacts (8) du composant, et des moyens de manoeuvre (20) étant destinés à faire pivoter des moyens de prise (1) vers leur position active et à amener les actionneurs (11) et donc les broches (9) de contact en contact avec les surfaces de contacts du composant, caractérisée en ce que les moyens de manoeuvre (20) sont capables d'exécuter un mouvement de rotation et comprennent un premier élément tournant à came (18) destiné à manoeuvrer les moyens de prise (1) et un second élément tournant à came (21) destiné à manoeuvrer les actionneurs (11), et en ce que les premier (18) et second (21) éléments tournants à came sont formés de manière qu'ils fassent d'abord pivoter les moyens de prise (1) vers leur position active de contact, puis qu'ils amènent ensuite les broches de contact (9) en contact avec les surfaces de contacts (8) des actionneurs (11).

2. Monture selon la revendication 1, caractérisée en ce que les moyens de prise (1) ont la forme d'une équerre de renvoi et en ce que le premier élément tournant à came (18) agit dans la direction de l'axe de rotation des moyens de manoeuvre sur un premier bras de l'équerre de renvoi durant le mouvement de rotation afin que l'autre bras soit déplacé vers l'axe de rotation, et en ce que le second élément tournant à came (21) comporte des ergots (22) situés à une certaine distance radiale de l'axe de rotation, lesdits ergots (22) faisant saillie dans des fentes (23) ménagées dans les actionneurs (11) dans une direction transversale à l'axe de rotation afine que, lorsque ʻl'on fait tourner les moyens de manoeuvre, les actionneurs (11) soient soumis à un mouvement les déplaçant dans une direction transversale vers l'axe de rotation.

*Fig. 1*

*Fig. 2*